# EUROPÄISCHE PATENTANMELDUNG

(11) **EP 4 468 326 A1**
(43) Veröffentlichungstag der Anmeldung: **27.11.2024**
(21) Anmeldenummer: 23175151.2
(22) Anmeldetag: 24.05.2023
(51) Int. Cl.: H01L 21/66

(54) **REFERENZ ZUR BESTIMMUNG DER HÖHENVARIATION EINER OBERFLÄCHE EINER SCHEIBE AUS HALBLEITERMATERIAL UND VERFAHREN ZUR BESTIMMUNG DER OBERFLÄCHENRAUHEIT VON SCHEIBEN AUS HALBLEITERMATERIAL**

(71) Anmelder: Siltronic AG, 81677 München (DE)
(72) Erfinder: Ehlert, Andreas, 84547 Emmerting (DE)
(74) Vertreter: Grundner, Sebastian

(57) **Zusammenfassung**

Verwendung mindestens einer ersten Scheibe aus Halbleitermaterial als Referenz zur Bestimmung der Höhenvariation einer Oberfläche einer zweiten Scheibe aus Halbleitermaterial, wobei die erste Scheibe aus Halbleitermaterial mindestens einen Oberflächendefekt aufweist, der mindestens eine Oberflächendefekt, in einem Abschnitt mit einer Länge in einer Richtung parallel zu einer Hauptfläche der ersten Scheibe aus Halbleitermaterial von nicht weniger als 10 nm und nicht mehr als 5000 nm, ein Höhenprofil mit einem niedrigsten und einem höchsten Punkt aufweist, und die Höhendifferenz zwischen dem niedrigsten und dem höchsten Punkt des Höhenprofils in dem Abschnitt nicht weniger als 5 pm und nicht mehr als 5000 pm beträgt.

## Beschreibung

### Technisches Gebiet

Die vorliegende Erfindung betrifft die Verwendung mindestens einer ersten Scheibe aus Halbleitermaterial als Referenz zur Bestimmung der Höhenvariation einer Oberfläche einer zweiten Scheibe aus Halbleitermaterial und ein Verfahren zur Bestimmung der Oberflächenrauheit von Scheiben aus Halbleitermaterial.

### Stand der Technik

Scheiben aus monokristallinem Halbleitermaterial (auch Wafer genannt) sind die Grundlage der modernen Elektronik. Während der Herstellung von Bauelementen auf besagten Halbleiterscheiben werden thermische Prozesse und komplexe Beschichtungsschritte durchgeführt. Die Oberflächenrauheit von Scheiben aus monokristallinem Halbleitermaterial, beispielsweise aus monokristallinem Silizium, hat einen entscheidenden Einfluss auf die spätere Funktionalität der Bauelemente.

Um Sicherzustellen, dass die Scheiben aus Halbleitermaterial den hohen Qualitätsanforderungen genügen, ist eine strenge Prozesskontrolle und Inspektion der produzierten Scheiben erforderlich. Dabei kommt der Oberflächeninspektion der Scheiben, insbesondere der Streulichtmessung und der Rasterkraftmikroskopie (AFM), eine große Bedeutung in der Qualitätssicherung zu.

Als Standardverfahren zur Detektion von Oberflächendefekten auf Scheiben aus Halbleitermaterial gelten Messverfahren, welche auf dem Prinzip der Lichtstreuung beruhen. Die Inspektion von Scheiben aus Halbleitermaterial hinsichtlich Kontamination und Beschädigung mit Hilfe von optischen Verfahren ist beispielsweise in der US RE37,740 E beschrieben, die ein Streulichtinspektionsgerät, mit dem die Oberfläche einer schnell rotierenden Scheibe mit einem Laser abgetastet wird, beschreibt. Solche Streulichtmess-Systeme liefern unter anderem Informationen über die Position der Defekte auf der Scheibenoberfläche sowie deren Größe. Diese Information wird in der Regel in elektronischer Form gespeichert, zumeist in einem standardisierten Dateiformat, so dass diese Information auch für nachfolgende analytische Messungen der Scheibe auf anderen Messgeräten zur Verfügung steht. Ein solches standardisiertes Dateiformat ist KLARF (**KLA R**eview **F**ile **F**ormat), welches Informationen über die Positionen von Defekten auf der Oberfläche einer Halbleiterscheibe und zusätzlich die Position dieser Defekte bezogen auf verschiedene Messgeräte speichert.

Methoden zur Messung der Rauheit von Halbleiterscheiben sowie die zugehörige Terminologie sind unter anderem in der Norm SEMI M40-1114 beschrieben. Unter den in dieser Norm erwähnten Methoden nimmt die Rasterkraftmikroskopie (AFM) eine besondere Stellung als Methode der Wahl zur Bestimmung der Oberflächenrauheit von Scheiben aus Halbleitermaterial ein. Die Funktionsweise eines Rasterkraftmikroskops ist beispielsweise in der US 2019 0 353 681 A1 beschrieben. Grundsätzlich kann mit der Kraft-Messsonde eines Rasterkraftmikroskops eine Oberfläche bis in den atomaren Bereich untersucht werden und eine Auflösung im Sub-Nanometer-Bereich, also eine Auflösung von weniger als 1 nm, erzielt werden.

Für eine präzise Messungen ist jedoch eine kalibrierte Skalierung erforderlich oder zumindest eine Referenz, die es ermöglicht, eine Abweichung der Messwerte im Sub-Nanometer-Bereich über die Zeit festzustellen, so dass eine Korrektur vorgenommen werden kann. Kommerziell erhältliche Kalibrierstandards für die Höhenmessungen decken jedoch nicht den Sub-Nanometer-Bereich ab. Eine genaue und reproduzierbare Messung der Oberflächenrauheit im Sub-Nanometer-Bereich ist also bei Verwendung kommerziell erhältlicher Kalibrierstandards nur schwer möglich.

Im Stand der Technik wird deshalb vorgeschlagen, Referenzproben mit definierten Oberflächenstrukturen herzustellen und diese dann als Standard für die Messung mit einem Rasterkraftmikroskop im Sub-Nanometer-Bereich zu verwenden.

So beschreiben Tsai et al. AIP Conference Proceedings 449, 839 (1998) die Verwendung eines Wafers aus einkristallinem Silizium mit der Kristallorientierung <111 >, der in einer Ultrahochvakuum-Umgebung behandelt wurde, als Kalibrierstandard im Sub-Nanometer-Bereich für ein Rasterkraftmikroskop. Die Höhe der einatomigen Stufen auf der Oberfläche eines solchen Wafers kann aus der Gitterkonstante von Silizium abgeleitet werden und somit als Standard für die Kalibrierung im Sub-Nanometer-Bereich herangezogen werden. Ein solcher Standard ist jedoch nicht zeitstabil. Somit ist die Reproduzierbarkeit eines Kalibrierverfahrens, das auf diesem Standard basiert, sehr eingeschränkt.

Dixson et al. Proc. of SPIE Vol. 7729 77290M (2010) verwenden eine Probe, bestehend aus einem Silizium-Substrat und einer auf dem Silizium-Substrat abgeschiedenen SiO₂-Schicht, welche ein Linienmuster mit einem Abstand von 70 nm und eine Stufenhöhe von ca. 35 nm aufweist, als Referenz im Sub-Nanometer-Bereich für die Rasterkraftm ikroskopie.

Zandiatashbar et al. Proc. of SPIE Vol. 9778 97782P (2016) beschreiben einen Prozess, bei dem die Oberfläche eines Wafers aus einkristallinem Silizium mit einer Gasphasenätze behandelt wurde und die resultierenden Topographieveränderungen mittels einem Rasterkraftmikroskop ausgemessen wurden.

Diese Verfahren sind allesamt aufwendig und erfordern oft spezielle Anlagen zu ihrer Herstellung, beispielsweise Anlagen in Ultrahochvakuum-Umgebung oder Anlagen zum Gasphasenätzen. Deshalb sind diese Verfahren, und damit die über sie hergestellten Standards, unwirtschaftlich und für die Prozesskontrolle und Qualitätssicherung ungeeignet. Außerdem sind die so erzeugten Oberflächenstrukturen nicht zeitstabil und können in bestimmten Fällen sogar zur Kontamination des Mess-Systems führen. Auch aus diesem Grund sind diese Standards für die Prozesskontrolle in der Halbleiterindustrie ungeeignet.

### Technische Aufgabe der Erfindung und deren Lösung

Der vorliegenden Erfindung liegt die Aufgabe zugrunde, eine zeitstabile Referenz für die Bestimmung der Höhenvariation einer Scheibe aus Halbleitermaterial im Sub-Nanometer-Bereich bereitzustellen. Insbesondere soll eine zeitstabile Referenz für die Bestimmung der Oberflächenrauheit einer Scheibe aus Halbleitermaterial im Sub-Nanometer-Bereich bereitgestellt werden, die für die industrielle Prozesskontrolle geeignet ist.

Gelöst wird die Aufgabe gemäß dem ersten Aspekt der vorliegenden Erfindung durch die Verwendung mindestens einer ersten Scheibe aus Halbleitermaterial als Referenz zur Bestimmung der Höhenvariation einer Oberfläche einer zweiten Scheibe aus Halbleitermaterial, wobei
die erste Scheibe aus Halbleitermaterial mindestens einen Oberflächendefekt aufweist,
der mindestens eine Oberflächendefekt, in einem Abschnitt mit einer Länge in einer Richtung parallel zu einer Hauptfläche der ersten Scheibe aus Halbleitermaterial von nicht weniger als 10 nm und nicht mehr als 5000 nm, ein Höhenprofil mit einem niedrigsten und einem höchsten Punkt aufweist, und
die Höhendifferenz zwischen dem niedrigsten und dem höchsten Punkt des Höhenprofils in dem Abschnitt nicht weniger als 5 pm und nicht mehr als 5000 pm beträgt.

Der zweite Aspekt der vorliegenden Erfindung betrifft ein Verfahren zur Bestimmung der Oberflächenrauheit von Scheiben aus Halbleitermaterial, umfassend die folgenden Schritte:
Auswählen mindestens einer ersten Scheibe aus Halbleitermaterial, die mindestens einen Oberflächendefekt aufweist, welcher, in einem Abschnitt mit einer Länge in einer Richtung parallel zu einer Hauptfläche von nicht weniger als 10 nm und nicht mehr als 5000 nm, ein Höhenprofil mit einem niedrigsten und einem höchsten Punkt aufweist, wobei die Höhendifferenz zwischen dem niedrigsten und dem höchsten Punkt in dem Abschnitt nicht weniger als 5 pm und nicht mehr als 5000 pm beträgt;
Kalibrieren eines Messgerätes zur Bestimmung der Höhenvariation einer Oberfläche, wobei die Höhendifferenz des Höhenprofils in dem Abschnitt der mindestens einen ersten Scheibe aus Halbleitermaterial als Referenzwert dient;
Messen der Höhenvariation der Hauptfläche mindestens einer zweiten Scheibe aus Halbleitermaterial mittels des kalibrierten Messgerätes; und
Verwenden der gemessenen Höhenvariation zur Bestimmung der Oberflächenrauheit der mindestens einen zweiten Scheibe.

Bevorzugte Ausführungsformen sind Gegenstand der abhängigen Ansprüche.

Die mindestens eine erste Scheibe aus Halbleitermaterial mit mindestens einem Oberflächendefekt kann als Referenz für die Bestimmung der Höhenvariation von Oberflächen weiterer Scheiben aus Halbleitermaterial verwendet werden. Solche erste Scheibe aus Halbleitermaterial können aus der industriellen Fertigung von Halbleiterscheiben stammen und bedürfen keiner weiteren Präparation oder Behandlung. Somit ist keine aufwendige Präparation dieser Scheiben erforderlich. Außerdem sind die Oberflächendefekte auf industriell gefertigten Scheiben über einen längeren Zeitraum stabil. Somit kann ohne präparativen Aufwand ein zeitstabiler Standard oder zumindest eine zeitstabile Referenz hergestellt werden. Dadurch können stabile und reproduzierbare Ergebnisse bei der Bestimmung der Höhenvariation der Oberfläche von Scheiben aus Halbleitermaterial im Rahmen der industriellen Prozesskontrolle erhalten werden. Außerdem ist die Wirtschaftlichkeit der Prozesskontrolle durch die Verwendung solcher industriell gefertigter, erster Scheiben als zeitstabile Referenz gewährleistet.

Eine Referenz im Sinne der vorliegenden Erfindung ist ein Bezugssystem mit mindestens einem bekannten Wert, der als Bezugspunkt für die Bestimmung weiterer Werte dient, wobei der mindestens eine bekannte Wert vorzugsweise die Höhendifferenz eines Höhenprofils ist. Ein Standard zum Kalibrieren ist eine Referenz im Sinne der vorliegenden Erfindung. Vorzugsweise ist der Bezugspunkt eine bekannte Höhendifferenz eines Höhenprofils, besonders bevorzugt die Höhendifferenz des in den unabhängigen Ansprüchen definierten Höhenprofils in einem bestimmten Abschnitt auf der Oberfläche der ersten Scheibe aus Halbleitermaterial, wobei diese Höhendifferenz als Bezugspunkt für die Bestimmung der Höhenvariation von weiteren (zweiten) Scheiben aus Halbleitermaterial dient. Der bestimmte Abschnitt auf der Oberfläche der Referenz ist vorzugsweise durch eine hohe Wiederauffindbarkeit gekennzeichnet. Die bekannte Höhendifferenz des Höhenprofils der Referenz wird im Folgenden auch als Referenzwert bezeichnet.

### Kurzbeschreibung der Figuren

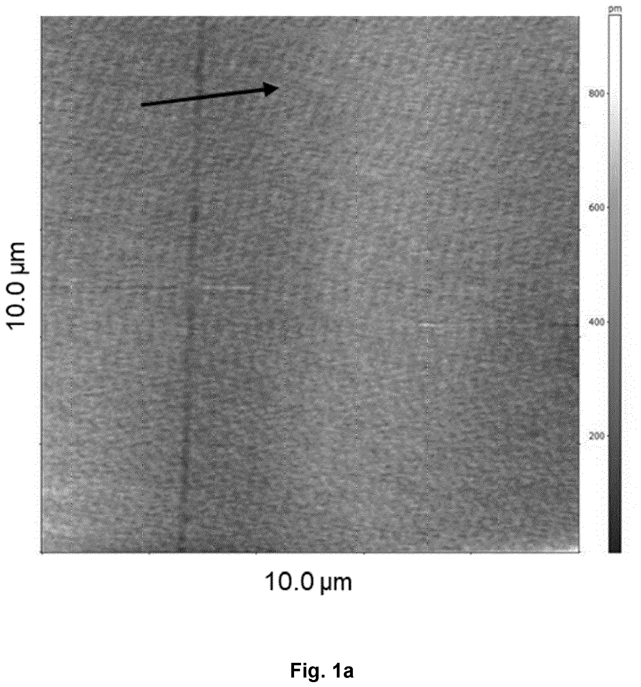

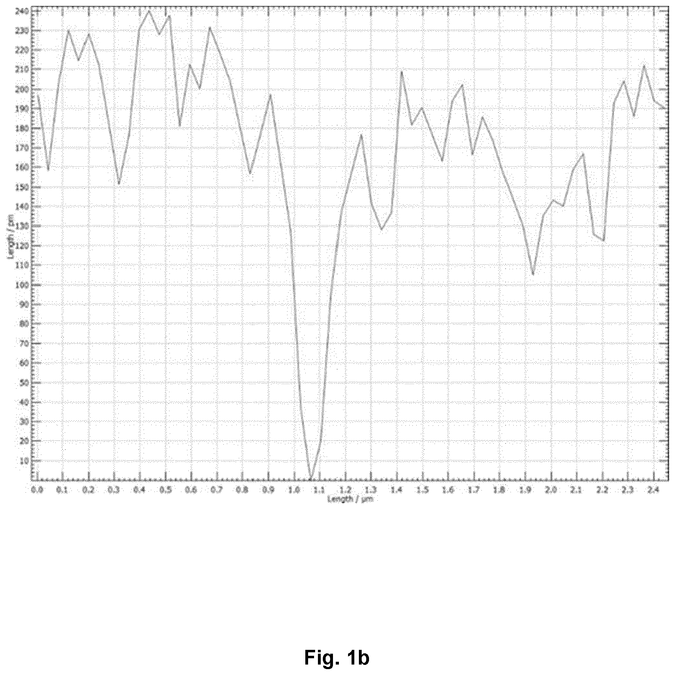

**Fig. 1** **a** zeigt ein Messfeld (10.0 µm × 10.0 µm) einer Rasterkraftmikroskopie-Aufnahme einer Oberfläche einer Scheibe aus einkristallinem Silizium. Ein flacher Oberflächenfehler ("Nanoscratch") verläuft vertikal durch das Bild und wird ungefähr auf halber Höhe von einem zweiten, horizontal verlaufenden Fehler gekreuzt.
Fig. 1 b zeigt das Höhenprofil eines Abschnittes des flachen Oberflächenfehlers in **Fig. 1a****.** Die horizontale Achse des dargestellten Höhenprofils entspricht dabei dem in **Fig. 1** **a** abgebildeten Pfeil. Die gemessene Höhendifferenz in diesem Abschnitt beträgt ca. 140 pm.
**Fig. 2** **a** zeigt ein Messfeld (10.0 µm × 10.0 µm) einer Rasterkraftmikroskopie-Aufnahme einer Oberfläche einer Scheibe aus einkristallinem Silizium mit einem flachen Oberflächenfehler (Polished Induced Defect - PID), welcher einen rechtwinkligen Verlauf aufweist.

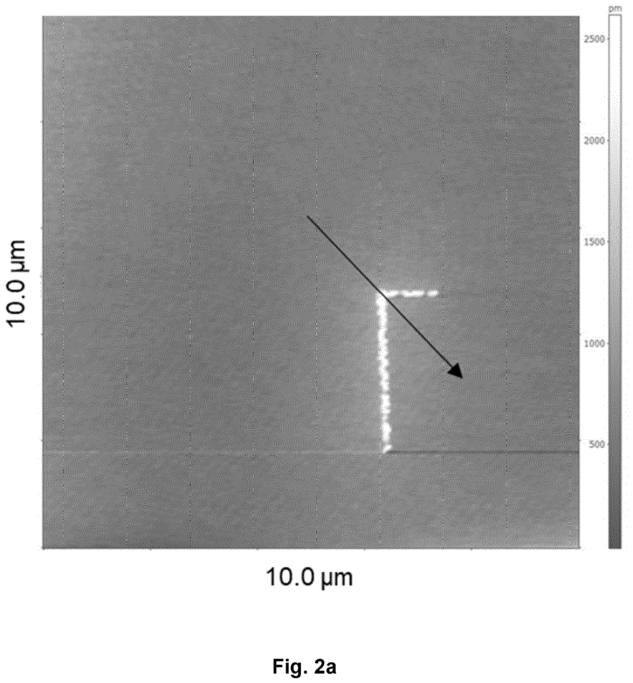

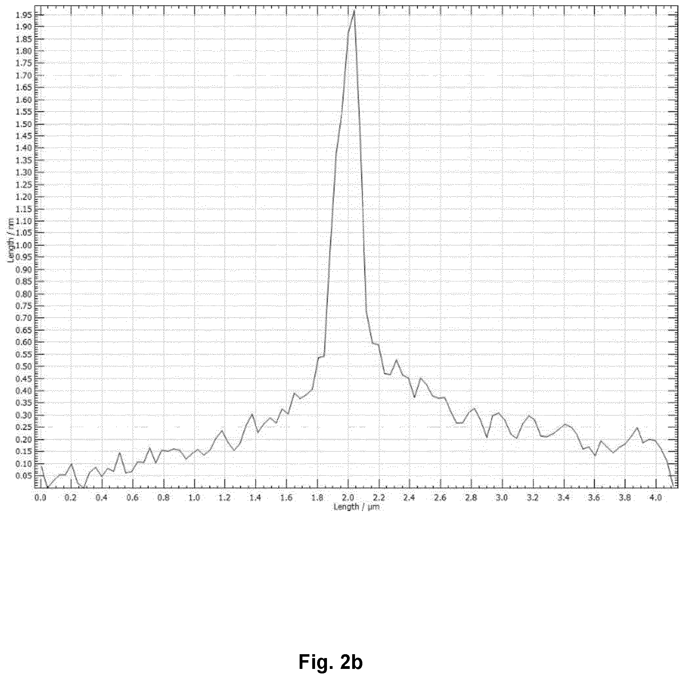

Fig. 2 b zeigt das Höhenprofil eines Abschnittes des flacher Oberflächenfehlers, der in **Fig. 2a** abgebildet ist. Die horizontale Achse des dargestellten Höhenprofils entspricht dabei dem in **Fig. 2** **a** abgebildeten Pfeil. Die gemessene Höhendifferenz in diesem Abschnitt beträgt ca. 1900 pm.

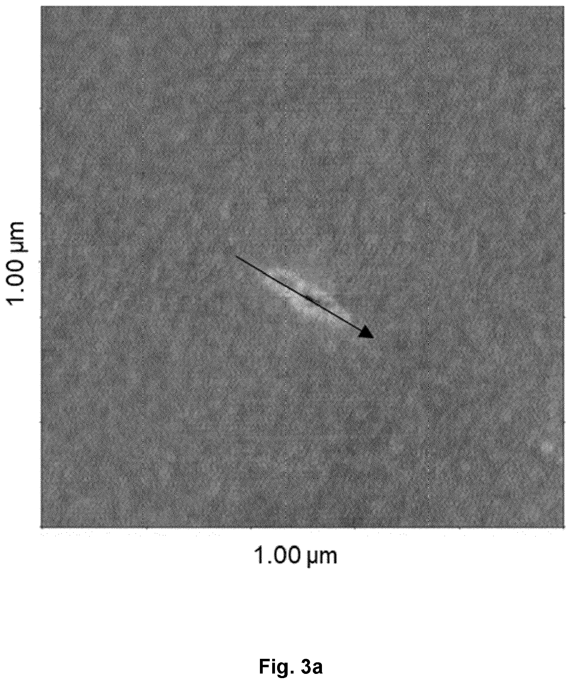

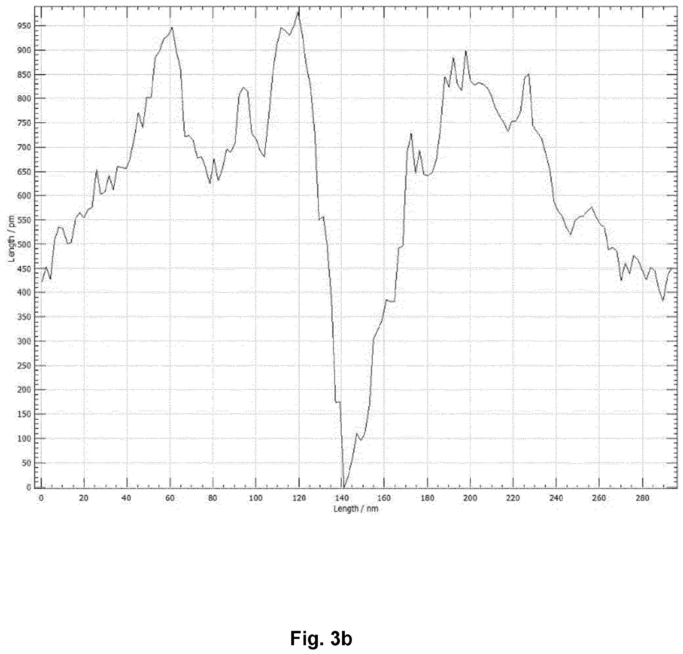

**Fig. 3** **a** zeigt ein Messfeld (1.0 µm × 1.0 µm) einer Rasterkraftmikroskopie-Aufnahme einer Oberfläche einer Scheibe aus einkristallinem Silizium. Ein flacher Oberflächenfehler verläuft diagonal durch die Bildmitte und ist durch einen Wechsel zwischen Vertiefungen und Erhebungen gekennzeichnet.
Fig. 3 b zeigt das Höhenprofil eines Abschnittes des in **Fig. 3** **a** dargestellten flachen Oberflächenfehlers. Die horizontale Achse des dargestellten Höhenprofils entspricht dabei dem in **Fig. 3** **a** abgebildeten Pfeil. Die gemessene Höhendifferenz in diesem Abschnitt beträgt ca. 950 pm.

### Detaillierte Beschreibung der Erfindung

Geeignete erste Scheiben aus Halbleitermaterial können aus der industriellen Fertigung ausgewählt werden. Dies kann im Rahmen der Qualitätskontrolle einer industriellen Fertigung von Scheiben aus Halbleitermaterial erfolgen, beispielsweise mittels Lichtstreumessung. Dabei können Oberflächendefekte identifiziert und deren Position und Größe mittels Lichtstreuung bestimmt werden. Basierend auf dem Ergebnis der Lichtstreumessung können so Scheiben aus Halbleitermaterial mit geeigneten Oberflächendefekten identifiziert und für weitere Messungen ausgewählt werden. Anschließend können die Oberflächendefekte der ausgewählten Scheiben mit einer zweiten Messmethode, beispielsweise Rasterkraftmikroskopie, untersucht werden und so Oberflächendefekte identifiziert werden, die mindestens einen Abschnitt mit einer Länge in einer Richtung parallel zu einer Hauptfläche von nicht weniger als 10 nm und nicht mehr als 5000 nm mit einer Höhendifferenz zwischen dem niedrigsten und dem höchsten Punkt des Höhenprofils in dem Abschnitt von nicht weniger als 5 pm und nicht mehr als 5000 pm aufweisen.

Der in den unabhängigen Ansprüchen definierte Abschnitt weist eine bestimmte Länge in einer Richtung parallel zur einer Hauptfläche auf, wobei die Länge lediglich die für die Bestimmung des Höhenprofils betrachtete Länge in einer Richtung parallel zu einer Hauptfläche der ersten Scheibe ist. Die Länge entspricht also nur dem Teil des Oberflächendefektes, dessen Höhenprofil betrachtet wird, und entspricht also nicht zwingend der maximalen Ausdehnung des Oberflächendefektes in dieser Richtung. Die bestimmte Richtung parallel zur einer Hauptfläche, in der die Länge bestimmt wurde, entspricht also der horizontalen Achse des Höhenprofils. Das Höhenprofil entspricht dem Verlauf der Höhenänderung entlang der Richtung parallel zu einer Hauptfläche der ersten Scheibe. Das Höhenprofil verläuft also entlang derselben Richtung, in der die Länge des Abschnittes bestimmt wurde. Die Höhe entspricht dabei der Richtung senkrecht zur Hauptfläche der ersten Scheibe aus Halbleitermaterial.

Die mit der ersten Messmethode, beispielsweise einer Lichtstreumessung, auf einem ersten Messgerät identifizierte Position der Oberflächendefekte kann als digitaler Datensatz, beispielsweise als KLARF-Datei, auf ein zweites Messgerät übertragen werden, so dass diese in der zweiten Messmethode, beispielsweise der Rasterkraftmikroskopie, auf einem zweiten Messgerät leicht wiederauffindbar und identifizierbar sind. KLARF ist ein Dateiformat, das Informationen über die Positionen von Defekten auf der Oberfläche einer Halbleiterscheibe und zusätzlich die Position dieser Defekt in den verschiedenen Messgeräten speichert. Somit kann die in der ersten Messung, vorzugsweise einer Lichtstreumessung, identifizierte Position der Oberflächendefekte direkt für die zweite Messung, vorzugsweise Rasterkraftmikroskopie, genutzt werden. Als zweite Messmethode eignet sich grundsätzlich die Rastersondenmikroskopie.

Vorzugsweise wird die Position des Abschnittes mit einer Länge in einer Richtung parallel zu einer Hauptfläche der Scheibe von nicht weniger als 10 nm und nicht mehr als 5000 nm und einer Höhendifferenz zwischen dem niedrigsten und dem höchsten Punkt in diesem Abschnitt von nicht weniger als 5 pm und nicht mehr als 5000 pm durch Angabe der Position eines quadratischen Messfeldes angegeben. Das quadratische Messfeld hat vorzugsweise eine Kantenlänge von nicht mehr als 10 µm, mehr bevorzugt nicht mehr als 1 µm, und besonders bevorzugt nicht mehr als 500 nm. Vorzugsweise hat das quadratische Messfeld eine Kantenlänge von nicht weniger als 50 nm, besonders bevorzugt nicht weniger 100 nm. Dabei wird die Position durch die Koordinaten der beiden Normalrichtungen parallel zur Hauptfläche der ersten Scheibe aus Halbleitermaterial angegeben. Die Koordinaten auf der Oberfläche der ersten Scheibe aus Halbleitermaterial können in Form von digitalen Datensätzen festgehalten und abgespeichert werden, beispielsweise im Dateiformat KLARF.

Der Abschnitt des mindestens einen Oberflächendefektes mit einer Länge in einer Richtung parallel zu einer Hauptfläche der ersten Scheibe aus Halbleitermaterial von nicht weniger als 10 nm und nicht mehr als 5000 nm und einem Höhenprofil mit einem niedrigsten und einem höchsten Punkt, wobei die Höhendifferenz zwischen dem niedrigsten und dem höchsten Punkt des Höhenprofils nicht weniger als 5 pm und nicht mehr als 5000 pm beträgt, kann dann als zeitstabile Referenz oder als Kalibrierstandard verwendet werden. Insbesondere kann die Höhendifferenz in diesem Abschnitt als Referenzwert für die Bestimmung der Höhenvariation verwendet werden.
Der Abschnitt und die Höhendifferenz in diesem Abschnitt kann jederzeit wieder identifiziert und vermessen werden. Dies ermöglicht es, das Messgerät zur Bestimmung der Höhenvariation zu kalibrieren und Abweichungen des Anzeigewertes des Messgerätes bei der Bestimmung der Höhenvariation über die Zeit festzustellen.

Die Höhenvariation im Sinne der vorliegenden Erfindung ist die Änderung der Höhe über die Oberfläche einer Scheibe aus Halbleitermaterial, insbesondere die Änderung der Höhe über die Hauptfläche einer Scheibe aus Halbleitermaterial. Die Höhe entspricht dabei der axialen Richtung einer Scheibe aus Halbleitermaterial, also der Richtung senkrecht zur Hauptfläche. Die Bestimmung der Höhenvariation ist die Vorrausetzung für die Bestimmung der Oberflächenrauheit.

Die festgestellte Abweichung der gemessenen Höhendifferenzen in dem oben spezifizierten Abschnitt eines Oberflächendefektes einer ersten Scheibe bei verschiedenen Messungen auf dem gleichen Messgerät kann in einem weiteren Schritt zur Korrektur der Bestimmung der Höhendifferenz verwendet werden. So kann in einem weiteren Schritt entweder durch eine Veränderung der Einstellungen des Messgerätes oder durch eine mathematische Korrektur der gemessenen und angezeigten Werte der Abweichung entgegengewirkt werden, so dass wieder der ursprüngliche Wert der Höhendifferenz in dem oben spezifizierten Abschnitt erreicht wird.

Dadurch können über die Zeit verlässliche und vergleichbare Messergebnisse erhalten werden, indem die erste Halbleiterscheibe in regelmäßigen Abständen als Referenz zur Überprüfung des Messgerätes und der Genauigkeit der mit dem Messgerät ermittelten Werte eingesetzt werden. Durch die Verwendung der ersten Scheibe aus Halbleitermaterial als Referenz zur Bestimmung der Höhenvariation einer Oberfläche einer zweiten Scheibe aus Halbleitermaterial ist eine zuverlässige Quantifizierung der Höhenvariation von (zweiten) Scheiben aus Halbleitermaterial im Sub-Nanometerbereich möglich.

Die erstmalige Bestimmung des Höhenprofils des mindestens einen Oberflächendefektes der mindestens einen ersten Scheibe, insbesondere eines Abschnittes mit einer Länge in einer Richtung parallel zu einer Hauptfläche der ersten Scheibe von nicht weniger als 10 nm und nicht mehr als 5000 nm, und einem Höhenprofil mit einem niedrigsten und einem höchsten Punkt mit einer Höhendifferenz zwischen dem niedrigsten und dem höchsten Punkt von nicht weniger als 5 pm und nicht mehr als 5000 pm in diesem Abschnitt, kann unter Verwendung eines nicht zeitstabilen und/oder aufwendig herzustellenden Standards erfolgen. Beispielsweise eignen sich die oben genannten, im Stand der Technik beschriebenen Herstellungsverfahren und Materialien zur Bereitstellung eines Kalibrierstandards für den Sub-Nanometerbreich. So ist eine präzise und zuverlässige Bestimmung der Höhendifferenz zwischen dem niedrigsten und dem höchsten Punkt in diesem Abschnitt und damit eine zuverlässige Bestimmung des Referenzwertes für die Bestimmung der Höhenvariation im Sub-Nanometer-Bereich möglich. Dies ist wiederum die Voraussetzung für die Verwendung der mindestens einen ersten Scheibe als Referenz für die Bestimmung der Höhenvariation einer zweiten Scheibe.

Die Verwendung der aufwendig herzustellenden Standards ist nur einmalig für die Bestimmung des Referenzwertes erforderlich. Nach der Bestimmung des Referenzwertes kann die erste Scheibe als zeitstabile Referenz wirtschaftlich und mit geringerem Aufwand langfristig in der Prozesskontrolle eingesetzt werden. Dadurch ist die anfängliche Verwendung aufwendig herzustellender und/oder nicht zeitstabiler Standards aus wirtschaftlicher und technischer Sicht unproblematisch, da diese nur für die Auswahl und Vermessung der Referenzscheiben erforderlich sind, nicht jedoch für die routinemäßige Kalibrierung und Referenzierung im Rahmen der Prozesskontrolle.

Die erste Scheibe aus Halbleitermaterial hat vorzugsweise einen Durchmesser von 150 mm bis 450 mm, besonders bevorzugt 200 mm bis 300 mm, am meisten bevorzugt 200 mm oder 300 mm. Die Scheibe aus Halbleitermaterial ist vorzugsweise eine Scheibe aus einkristallinem Silizium. Die Scheibe aus Halbleitermaterial kann auch mittels Abscheidung aus der Gasphase mit Silizium, Germanium, Siliziumcarbid oder Galliumnitrid beschichtet sein. Der Rand der Scheibe ist vorzugsweise abgerundet. Der abgerundete Rand der Scheibe ist definiert als der radiale, ringförmige Randbereich, in dem sich die Dicke der Scheibe in Radialauswärtsrichtung verringert oder verjüngt. Dabei ist unter der Dicke der Scheibe die axiale Ausdehnung senkrecht zur radialen Richtung zu verstehen, also senkrecht zu den Hauptflächen an der Vorder- und Rückseite der Scheibe.

Unter einem Oberflächendefekt ist ein Defekt zu verstehen, der an der Hauptfläche der Vorder- oder Rückseite, vorzugsweise der Vorderseite, der ersten Scheibe auftritt. Der Oberflächendefekt verläuft vorzugsweise parallel zu einer Hauptfläche und an der Oberfläche der Hauptfläche. Vorzugsweise ist der Oberflächendefekt ein flacher Oberflächenfehler, beispielsweise ein Kratzer ("Nanoscratch"), wie in **Fig. 1a** dargestellt, oder ein während des Poliervorgans erzeugter Oberflächenfehler ("PID"), wie in **Fig. 2a** dargestellt. Der Oberflächenfehler kann geradlinig oder abgewinkelt entlang der Oberfläche verlaufen. Der Oberflächenfehler hat vorzugsweise eine maximale Tiefe von nicht mehr als 50 nm, mehr bevorzugt von nicht mehr als 10 nm, besonders bevorzugt von nicht mehr als 5 nm.

Der mindestens eine Oberflächendefekt der ersten Scheibe weist einen Abschnitt auf, der dadurch gekennzeichnet ist, dass der Abschnitt in einer Richtung parallel zu einer Hauptfläche auf eine Länge von nicht weniger als 10 nm und nicht mehr als 5000 nm ein Höhenprofil mit einem niedrigsten und einem höchsten Punkt aufweist, wobei die Höhendifferenz zwischen dem niedrigsten und dem höchsten Punkt der oberfläche in diesem Abschnitt nicht weniger als 5 pm und nicht mehr als 5000 pm beträgt. Die Länge des Abschnittes entspricht der Ausdehnung des Abschnittes in der Richtung parallel zur Hauptfläche der ersten Scheibe aus Halbleitermaterial. Die Hauptfläche ist dabei einer der Hauptflächen an der Vorder- und Rückseite der Scheibe.

Die Höhendifferenz ergibt sich dabei aus der Differenz der Höhenposition des niedrigsten und des höchsten Punktes in dem Abschnitt mit einer Länge in einer Richtung parallel zu einer Hauptfläche von nicht weniger als 10 nm und nicht mehr als 5000 nm. Die Differenz der Höhenposition entspricht dabei dem axialen Abstand zwischen dem in axialer Richtung niedrigsten Punkt und den in axialer Richtung höchsten Punkt auf der Oberfläche in diesem Abschnitt. Die axiale Richtung ist dabei die Richtung senkrecht zu einer Hauptfläche der ersten Scheibe aus Halbleitermaterial. Die Höhe (axiale Richtung) entspricht also der Richtung senkrecht zur Länge des Abschnittes. Die Höhendifferenz zwischen dem niedrigsten und dem höchsten Punkt in dem Abschnitt mit einer Länge in einer Richtung parallel zu einer Hauptfläche von nicht weniger als 10 nm und nicht mehr als 5000 nm entspricht also dem axialen Abstand der beiden in axialer Richtung am weitesten voneinander entfernten Punkte an der Oberfläche in diesem Abschnitt.

Die Höhendifferenz zwischen dem niedrigsten und dem höchsten Punkt in dem Abschnitt mit einer Länge in einer Richtung parallel zu einer Hauptfläche von nicht weniger als 10 nm und nicht mehr als 5000 nm beträgt vorzugsweise nicht weniger als 30 pm und nicht mehr als 5000 pm, besonders bevorzugt nicht weniger als 30 pm und nicht mehr als 1000 pm. In einer weiteren, besonders bevorzugten Ausführungsform beträgt die Höhendifferenz zwischen dem niedrigsten und dem höchsten Punkt nicht weniger als 50 pm und nicht mehr als 5000 pm, mehr bevorzugt nicht weniger als 50 pm und nicht mehr als 1000 pm, am meisten bevorzugt nicht weniger als 50 pm und nicht mehr als 500 pm.

Eine Höhendifferenz von nicht weniger als 30 pm erleichtert die Reproduzierbarkeit der Messung der Referenz. Eine Höhendifferenz von nicht weniger als 50 pm verbessert die Reproduzierbarkeit der Messung weiter. Eine Höhendifferenz von nicht mehr als 5000 pm ist als Referenzwert für die Messung der Höhenvariation im Sub-Nanometer-Bereich geeignet. Ein Höhendifferenz von nicht mehr als 1000 pm ist besonders geeignet als Referenz für die Messung der Höhenvariation im Sub-Nanometer-Bereich. Damit liegt die Höhendifferenz in derselben Größenordnung wie die Oberflächenrauheit von modernen, industriell produzierten Scheiben aus monokristallinem Silizium. Diese weisen eine Variation der Oberflächenrauheit im Bereich von 30 bis 300 pm auf. Es werden also als erste Scheiben aus Halbleitermaterial vorzugsweise solche Scheiben ausgewählt, bei denen ein Abschnitt des Oberflächendefektes eine Höhendifferenz aufweist, die in derselben Größenordnung wie die Oberflächenrauheit von industriell gefertigten Halbleiterscheiben aus monokristallinem Silizium liegt. Die so ausgewählten ersten Scheiben aus Halbleitermaterial sind dadurch besonders gut als Referenz für die Bestimmung der Höhenvariation, insbesondere der Oberflächenrauheit, von zweiten Scheiben aus Halbleitermaterial geeignet.

Vorzugsweise hat der Oberflächendefekt, und insbesondere der Abschnitt mit einer Länge von nicht weniger als 10 nm und nicht mehr als 5000 nm entlang einer Richtung parallel zu einer Hauptfläche der Scheibe und mit einer Höhendifferenz zwischen dem niedrigsten und dem höchsten Punkt in diesem Abschnitt von nicht weniger als 5 pm und nicht mehr als 5000 pm, eine charakteristische Position, die die Wiederauffindbarkeit erleichtert. Dies ist besonders dann vorteilhaft, wenn die Position des Oberflächendefektes, und insbesondere des oben spezifizierten Abschnittes, nur durch Angabe eines Quadranten mit einer relativ großen Kantenlänge von mehreren Mikrometern identifiziert und festgehalten ist.

So befindet sich der oben spezifizierte Abschnitt vorzugsweise an oder in der Nähe einer Stelle an der Oberfläche der ersten Scheibe aus Halbleitermaterial, an der sich zwei Oberflächendefekte kreuzen, wie beispielsweise in **Fig. 1a** dargestellt. Ein Oberflächendefekt befindet sich dann in der Nähe einer Stelle wenn er weniger als 5 µm, vorzugsweise weniger als 3 µm, von dieser Stelle entfernt ist. Dies erleichtert die Wiederauffindbarkeit des Abschnittes des mindestens einen Oberflächendefektes, der als Referenz für die Bestimmung der Höhenvariation verwendet werden soll.

In einer weiteren, bevorzugten Ausführungsform befindet sich der Abschnitt an oder in der Nähe einer Stelle des mindestens einen Oberflächendefekts, an der der Defekt einen nicht geradlinigen Verlauf nimmt, beispielsweise eine Stelle, an der ein Oberflächenfehler die Richtung in der Ebene parallel zur Hauptfläche ändert, so dass der Defekt in axialer Blickrichtung einen Winkel bildet. Vorzugsweise ist der Abschnitt am Winkelscheitel eines solchen Oberflächenfehlers angeordnet. Beispielsweise kann der Oberflächendefekt, wie in **Fig. 2a** gezeigt, einen rechtwinkligen Verlauf nehmen, wobei der Abschnitt mit einer Länge in einer Richtung parallel zu einer Hauptfläche der ersten Scheibe von nicht weniger als 10 nm und nicht mehr als 5000 nm und einer Höhendifferenz zwischen dem niedrigsten und dem höchsten Punkt in diesem Abschnitt von nicht weniger als 5 pm und nicht mehr als 5000 pm durch den rechten Winkel verläuft oder an den Winkel angrenzt.

In einer weiteren Ausführungsform weist das Höhenprofil in dem oben spezifizierten Abschnitt innerhalb einer Länge von nicht mehr als 500 nm ein Minimum und ein Maximum auf. Das Minimum kann ein globales oder ein lokales Minimum sein. Das Maximum kann ein globales oder ein lokales Maximum sein. Das Maximum ist bevorzugt eine Erhöhung, also oberhalb des Nullpunktes der Höhenskala gelegen. Das Minimum ist bevorzugt eine Vertiefung, also unterhalb des Nullpunktes der Höhenskala gelegen. Der Wechsel zwischen Erhöhung und Vertiefung innerhalb einer Länge von nicht mehr als 500 nm, wie beispielsweise in **Fig. 3a** und **Fig. 3b** dargestellt, erleichtert die Wiederauffindbarkeit und ermöglicht es zudem, den Abschnitt gleichzeitig als Referenz für die Quantifizierung der Abweichung der axialen Höhe vom Nullpunkt in beide Richtungen (positive und negative Höhe) zu verwenden.

Diese speziellen Ausgestaltungen erleichtert die Wiederauffindbarkeit des Abschnittes und damit seine Verwendung als Referenz für die Bestimmung der Höhenvariation einer Oberfläche einer oder mehrerer zweiter Scheiben.

Grundsätzlich kann der Oberflächendefekt auf der Oberfläche der ersten Halbleiterscheibe, der als Referenz verwendet werden soll, auch markiert werden, um so die Wiederauffindbarkeit zu erleichtern. Dafür kann beispielsweise das in der EP 4 044 217 A1 offenbarte Verfahren verwendet werden und so der Oberflächendefekt und damit der als Referenz herangezogene Abschnitt mit einem Eindrückwerkzeug markiert werden.

Der zweite Aspekt der vorliegenden Erfindung betrifft ein Verfahren zur Bestimmung der Oberflächenrauheit von Scheiben aus Halbleitermaterial, umfassend die folgenden Schritte:
Auswählen mindestens einer ersten Scheibe aus Halbleitermaterial, die mindestens einen Oberflächendefekt aufweist, welcher, in einem Abschnitt mit einer Länge in einer Richtung parallel zu einer Hauptfläche von nicht weniger als 10 nm und nicht mehr als 5000 nm, ein Höhenprofil mit einem niedrigsten und einem höchsten Punkt aufweist, wobei die Höhendifferenz zwischen dem niedrigsten und dem höchsten Punkt in dem Abschnitt nicht weniger als 5 pm und nicht mehr als 5000 pm beträgt;
Kalibrieren eines Messgerätes zur Bestimmung der Höhenvariation einer Oberfläche, wobei die Höhendifferenz des Höhenprofils in dem Abschnitt der mindestens einen ersten Scheibe aus Halbleitermaterial als Referenzwert dient;
Messen der Höhenvariation der Hauptfläche mindestens einer zweiten Scheibe aus Halbleitermaterial mittels des kalibrierten Messgerätes; und
Verwenden der gemessenen Höhenvariation zur Bestimmung der Oberflächenrauheit der mindestens einen zweiten Scheibe.

Die Oberflächenrauheit der mindestens einen zweiten Scheibe wird vorzugsweise ausgedrückt als Mittenrauwertes Ra oder der quadratischen Rauheit Rq.

Der Mittenrauwert Ra und die quadratische Rauheit Rq sind in den Normen SEMI M40-1114 und ASME B46.1 definiert. Diese Normen enthalten zudem Vorschriften zur Bestimmung dieser Werte mittels Rasterkraftmikroskopie.

Die als Referenzwert verwendete Höhendifferenz beträgt, in einem Abschnitt mit einer Länge von nicht weniger als 10 nm und nicht mehr als 5000 nm, vorzugsweise nicht weniger als 30 pm und nicht mehr als 5000 pm, besonders bevorzugt nicht weniger als 30 pm und nicht mehr als 1000 pm. In einer weiteren, besonders bevorzugten Ausführungsform beträgt die Höhendifferenz zwischen dem niedrigsten und dem höchsten Punkt nicht weniger als 50 pm und nicht mehr als 5000 pm, mehr bevorzugt nicht weniger als 50 pm und nicht mehr als 1000 pm, am meisten bevorzugt nicht weniger als 50 pm und nicht mehr als 500 pm. Eine Höhendifferenz von nicht weniger als 30 pm erleichtert die Reproduzierbarkeit der Messung der Referenz. Eine Höhendifferenz von nicht weniger als 50 pm verbessert die Reproduzierbarkeit der Messung weiter. Eine Höhendifferenz von nicht mehr als 5000 pm ist als Referenzwert für die Messung der Höhenvariation im Sub-Nanometer-Bereich geeignet. Ein Höhendifferenz von nicht mehr als 1000 pm ist besonders geeignet als Referenz für die Messung der Höhenvariation im Sub-Nanometer-Bereich.

Das Kalibrieren des Messgerätes zur Bestimmung der Höhenvariation einer Oberfläche umfasst vorzugsweise die folgenden Schritte:
Messen des Höhenprofiles des Abschnittes der mindestens einen ersten Scheibe aus Halbleitermaterial mittels des Messgerätes zur Bestimmung der Höhenvariation einer Oberfläche;
Bestimmen der Höhendifferenz zwischen dem niedrigsten und dem höchsten Punkt des Höhenprofiles des Abschnittes der mindestens einen ersten Scheibe; und
Einstellen des Anzeigewertes des Messgerätes zur Bestimmung der Höhenvariation einer Oberfläche, so dass die mit dem Messgerät bestimmte Höhendifferenz und der Referenzwert innerhalb der Messgenauigkeitsgrenzen denselben Wert haben.

Erfolgt die Kalibrierung unter Verwendung mehrere Referenzwerte, so kann eine Kalibriergerade erstellt und der Anzeigewert auf der Grundlage dieser Geraden eingestellt werden.

Die zur erstmaligen Bestimmung des Referenzwertes erforderliche Kalibrierung des Messgerätes kann unter Verwendung eines anderen Standards erfolgen, beispielsweise eines der im Abschnitt "Stand der Technik" diskutierten Standards für die rasterkraftmikroskopische Messung im Sub-Nanometer-Bereich.

Das Messgerät zur Bestimmung der Höhenvariation einer Oberfläche ist vorzugsweise ein Rastersondenmikroskop, besonders bevorzugt ein Rasterkraftmikroskop.

### Beschreibung eines erfindungsgemäßen Ausführungsbeispiels

Zur Bestimmung der Koordinaten der Oberflächendefekte wurden kommerziell erhältliche Lichtstreumess-Systeme der Hersteller KLA Tencor Corp. und Hitachi High-Tech Corp. verwendet. Diese Lichtstreumess-Systeme wurden unter Reinraumbedingungen betrieben und lieferten unter anderem die Koordinaten von Defekten auf Halbleiterscheiben aus einkristallinem Silizium mit einem Durchmesser von 300 mm. Diese Koordinaten wurden als Datensatz in Form einer KLARF-Datei notiert und gespeichert.

Eine Halbleiterscheibe sowie die elektronische KLARF-Datei wurden nach Beendigung der Inspektion auf ein kommerziell verfügbares Rasterkraftmikroskop des Typs NX-Wafers des Herstellers Park Systems oder ein Rasterkraftmikroskop des Herstellers Semilab Semiconductor Physics Laboratory Co. Ltd. übertragen. Das Rasterkraftmikroskope des Typs NX-Wafers wurde unter Reinraumbedingungen betrieben, während das Rasterkraftmikroskop des Herstellers Semilab Semiconductor Physics Laboratory Co. Ltd. in gereinigter Luft unter Normalbedingungen betrieben wurde.

Die Halbleiterscheibe wurde anschließend auf dem jeweiligen Rasterkraftmikroskop positioniert, vorzugsweise mit Hilfe einer optischen Einrichtung (CCD-Kamera und/oder optischem Auflichtmikroskop). Die Positionierung erfolgte entweder manuell durch einen Bediener oder automatisiert mit Hilfe einer Robotereinheit und einem im Rasterkraftmikroskop integrierten Wafer-Aligner.

Im Anschluss erfolgte unter Nutzung der elektronischen KLARF-Datei, und gegebenenfalls einer Vorauswahl geeigneter Defekte aus der KLARF-Datei, die Bild- und Datenaufnahme der vorselektierten Defekte im Rasterkraftmikroskop. Mittels standardisierter Auswerteroutinen, welche in den kommerziellen Rasterkraftmikroskopen verfügbar sind, wurden die in **Fig. 1a** bis **3a** gezeigten rastermikroskopischen Aufnahmen erhalten und die in **Fig. 1b** bis **3b** dargestellten Höhenprofile ermittelt.

Auf der Grundlage der so ermittelten rastermikroskopischen Aufnahmen und der entsprechenden Höhenprofile konnten die drei in **Fig. 1** bis **3** abgebildeten Oberflächendefekte als geeignete Referenzen für die Bestimmung der Höhenvariation identifiziert und die entsprechenden Scheiben für die Prozesskontrolle industriell hergestellter Scheiben aus Halbleitermaterial eingesetzt werden.

## Patentansprüche

1. Verwendung mindestens einer ersten Scheibe aus Halbleitermaterial als Referenz zur Bestimmung der Höhenvariation einer Oberfläche einer zweiten Scheibe aus Halbleitermaterial, wobei
die erste Scheibe aus Halbleitermaterial mindestens einen Oberflächendefekt aufweist,
der mindestens eine Oberflächendefekt, in einem Abschnitt mit einer Länge in einer Richtung parallel zu einer Hauptfläche der ersten Scheibe aus Halbleitermaterial von nicht weniger als 10 nm und nicht mehr als 5000 nm, ein Höhenprofil mit einem niedrigsten und einem höchsten Punkt aufweist, und
die Höhendifferenz zwischen dem niedrigsten und dem höchsten Punkt des Höhenprofils in dem Abschnitt nicht weniger als 5 pm und nicht mehr als 5000 pm beträgt.

2. Verwendung mindestens einer ersten Scheibe aus Halbleitermaterial als Referenz zur Bestimmung der Höhenvariation einer Oberfläche einer zweiten Scheibe aus Halbleitermaterial gemäß dem Anspruch 1, wobei die Höhendifferenz zwischen dem niedrigsten und dem höchsten Punkt des Höhenprofils, in einem Abschnitt mit einer Länge in einer Richtung parallel zu einer Hauptfläche von nicht weniger als 100 nm und nicht mehr als 5000 nm, nicht weniger als 30 pm und nicht mehr als 1000 pm beträgt.

3. Verwendung mindestens einer ersten Scheibe aus Halbleitermaterial als Referenz zur Bestimmung der Höhenvariation einer Oberfläche einer zweiten Scheibe aus Halbleitermaterial gemäß dem Anspruch 1 oder 2, wobei die Höhendifferenz zwischen dem niedrigsten und dem höchsten Punkt des Höhenprofils, in einem Abschnitt mit einer Länge in einer Richtung parallel zu einer Hauptfläche von nicht weniger als 100 nm und nicht mehr als 5000 nm, nicht weniger als 50 pm und nicht mehr als 500 pm beträgt.

4. Verwendung mindestens einer ersten Scheibe aus Halbleitermaterial als Referenz zur Bestimmung der Höhenvariation einer Oberfläche einer zweiten Scheibe aus Halbleitermaterial gemäß einem der Ansprüche 1 bis 3, wobei die Höhendifferenz zwischen dem niedrigsten und dem höchsten Punkt des Höhenprofils in dem Abschnitt als Referenzwert zur Bestimmung der Höhenvariation der Oberfläche der zweiten Scheibe aus Halbleitermaterial verwendet wird.

5. Verwendung mindestens einer ersten Scheibe aus Halbleitermaterial als Referenz zur Bestimmung der Höhenvariation einer Oberfläche einer zweiten Scheibe aus Halbleitermaterial gemäß einem der Ansprüche 1 bis 4, wobei das Höhenprofils des mindestens eine Oberflächendefekts in dem Abschnitt mindestens einen Extremwert aufweist.

6. Verwendung mindestens einer ersten Scheibe aus Halbleitermaterial als Referenz zur Bestimmung der Höhenvariation einer Oberfläche einer zweiten Scheibe aus Halbleitermaterial gemäß einem der Ansprüche 1 bis 5, wobei sich der Abschnitt an einer Position der Oberfläche der ersten Scheibe aus Halbleitermaterial befindet, an der (i) sich zwei Oberflächendefekte kreuzen, (ii) ein Oberflächendefekte die Richtung in der Ebene parallel zur Hauptfläche ändert, (iii) das Höhenprofil innerhalb einer Länge von nicht mehr als 500 nm in einer Richtung parallel zu einer Hauptfläche ein Minimum und ein Maximum aufweist, oder (iv) eine Markierung mittels eines Eindrückwerkzeuges stattgefunden hat.

7. Verwendung mindestens einer ersten Scheibe aus Halbleitermaterial als Referenz zur Bestimmung der Höhenvariation einer Oberfläche einer zweiten Scheibe aus Halbleitermaterial gemäß einem der Ansprüche 1 bis 6, wobei die Position des mindestens einen Oberflächendefektes auf der Oberfläche der mindestens einen ersten Scheibe aus Halbleitermaterial auf einem elektronischen Speichermedium gesichert ist.

8. Verwendung mindestens einer ersten Scheibe aus Halbleitermaterial als Referenz zur Bestimmung der Höhenvariation einer Oberfläche einer zweiten Scheibe aus Halbleitermaterial gemäß einem der Ansprüche 1 bis 7, wobei das Messgerät zur Bestimmung der Höhenvariation der Oberfläche der zweiten Scheibe ein Rastersondenmikroskop, vorzugsweise ein Rasterkraftmikroskop, ist.

9. Verfahren zur Bestimmung der Oberflächenrauheit von Scheiben aus Halbleitermaterial, umfassend die folgenden Schritte:
Auswählen mindestens einer ersten Scheibe aus Halbleitermaterial, die mindestens einen Oberflächendefekt aufweist, welcher, in einem Abschnitt mit einer Länge in einer Richtung parallel zu einer Hauptfläche von nicht weniger als 10 nm und nicht mehr als 5000 nm, ein Höhenprofil mit einem niedrigsten und einem höchsten Punkt aufweist, wobei die Höhendifferenz zwischen dem niedrigsten und dem höchsten Punkt in diesem Abschnitt nicht weniger als 5 pm und nicht mehr als 5000 pm beträgt;
Kalibrieren eines Messgerätes zur Bestimmung der Höhenvariation einer Oberfläche, wobei die Höhendifferenz des Höhenprofils in dem Abschnitt der mindestens einen ersten Scheibe aus Halbleitermaterial als Referenzwert dient;
Messen der Höhenvariation der Hauptfläche mindestens einer zweiten Scheibe aus Halbleitermaterial mittels des kalibrierten Messgerätes; und
Verwenden der gemessenen Höhenvariation zur Bestimmung der Oberflächenrauheit der mindestens einen zweiten Scheibe.

10. Verfahren zur Bestimmung der Oberflächenrauheit von Scheiben aus Halbleitermaterial gemäß dem Anspruch 9,
wobei die Höhendifferenz zwischen dem niedrigsten und dem höchsten Punkt des Höhenprofils, in einem Abschnitt mit einer Länge in einer Richtung parallel zu einer Hauptfläche von nicht weniger als 100 nm und nicht mehr als 5000 nm, nicht weniger als 30 pm und nicht mehr als 1000 pm beträgt.

11. Verfahren zur Bestimmung der Oberflächenrauheit von Scheiben aus Halbleitermaterial gemäß dem Anspruch 9 oder 10,
wobei die Höhendifferenz zwischen dem niedrigsten und dem höchsten Punkt des Höhenprofils, in einem Abschnitt mit einer Länge in einer Richtung parallel zu einer Hauptfläche von nicht weniger als 100 nm und nicht mehr als 5000 nm, nicht weniger als 50 pm und nicht mehr als 500 pm beträgt.

12. Verfahren zur Bestimmung der Oberflächenrauheit von Scheiben aus Halbleitermaterial gemäß einem der Ansprüche 9 bis 11,
wobei das Kalibrieren des Messgerätes zur Bestimmung der Höhenvariation einer Oberfläche die folgenden Schritte umfasst:
Messen des Höhenprofiles des Abschnittes der mindestens einen Scheibe aus Halbleitermaterial mittels des Messgerätes zur Bestimmung der Höhenvariation einer Oberfläche;
Bestimmen der Höhendifferenz zwischen dem niedrigsten und dem höchsten Punkt des Höhenprofiles des Abschnittes der mindestens einen Scheibe; und
Einstellen des Anzeigewertes des Messgerätes zur Bestimmung der Höhenvariation einer Oberfläche, so dass die mit dem Messgerät bestimmte Höhendifferenz und der Referenzwert innerhalb der Messgenauigkeitsgrenzen denselben Wert haben.

13. Verfahren zur Bestimmung der Oberflächenrauheit von Scheiben aus Halbleitermaterial gemäß einem der Ansprüche 9 bis 12, wobei das Messgerät zur Bestimmung der Höhenvariation einer Oberfläche ein Rastersondenmikroskop, vorzugsweise ein Rasterkraftmikroskop, ist.

14. Verfahren zur Bestimmung der Oberflächenrauheit von Scheiben aus Halbleitermaterial gemäß einem der Ansprüche 9 bis 13, wobei die Oberflächenrauheit der mindestens einen zweiten Scheibe ausgedrückt wird als Mittenrauwertes Ra oder der quadratischen Rauheit Rq.
